Europäisches Patentamt

(19) European Patent Office

Office européen des brevets

(11) Veröffentlichungsnummer: **0 025 876**

**A1**

(12) **EUROPÄISCHE PATENTANMELDUNG**

(21) Anmeldenummer: **80104959.4**

(22) Anmeldetag: **21.08.80**

(51) Int. Cl.³: **H 04 B 1/40**
**H 03 L 7/18**

(30) Priorität: **20.09.79 DE 2937985**

(43) Veröffentlichungstag der Anmeldung:
**01.04.81 Patentblatt 81/13**

(84) Benannte Vertragsstaaten:
**AT DE FR GB IT NL SE**

(71) Anmelder: **ROBERT BOSCH GMBH**
**Postfach 50**
**D-7000 Stuttgart 1(DE)**

(72) Erfinder: **Gorzel, Heribert, Dipl.Ing.**
**Forstweg 33 c**
**D-1000 Berlin 28(DE)**

(72) Erfinder: **Liehn, Hans-Joachim**
**Thomasiusstrasse 14**
**D-1000 Berlin 21(DE)**

(74) Vertreter: **Schmidt, Hans-Ekhardt**
**Robert Bosch GmbH Geschäftsbereich Elektronik**
**Patent- und Lizenzabteilung Forckenbeckstrasse 9-13**
**D-1000 Berlin 33(DE)**

(54) **Mehrkanaliges Funksprechgerät.**

(57) Es wird ein mehrkanaliges Funksprechgerät vorgeschlagen, das eine PLL-Oszillatorschaltung aufweist. Eine vom Rechenwerk (2) jeder Kanalfrequenz zugeordnete Spannung wird kurzzeitig auf den Tiefpaß (7) der PLL-Schaltung aufgeschaltet, die als Steuerspannung für den steuerbaren Oszillator (8) dient, so daß die Ausgangsfrequenz des steuerbaren Oszillators (8) sofort dicht bei der Sollfrequenz liegt.

EP 0 025 876 A1

31/79
19. Sept. 1979
EK/PLI - Bt/Li

ROBERT BOSCH GMBH, 7000 Stuttgart

Mehrkanaliges Funksprechgerät

Stand der Technik

Die Erfindung geht aus von einem Funksprechgerät nach der
Gattung des Hauptanspruchs. Ein derartiges Gerät ist aus
der deutschen Offenlegungsschrift 26 07 992 bekannt. Dieses
Gerät hat aber den Nachteil, daß keine Schaltungsanordnung
zum schnellen Frequenzfang, das heißt zur Verkürzung der
Einrastzeit eines PLL, vorgesehen ist.

Aus der DE-AS 19 23 297 ist eine Oszillatorschaltung für
Frequenzsynthesegeräte bekannt, bei denen die Grobabstimmung
der Oszillatorfrequenz mit Hilfe von digitalen Steuersignalen
vorgenommen wird. Die digitalen Steuersignale schalten
Zusatzinduktivitäten parallel zu dem Schwingkreis des Oszillators. Dadurch werden unterschiedliche Frequenzen grob eingestellt. Diese Oszillatorschaltung hat den Nachteil, daß
mehrere Spulen zusätzlich vorgesehen werden müssen, so daß
der Schaltungsaufwand vergrößert wird. Außerdem ist die Einrastzeit des PLL noch zu lang.

- 2 -

31/79 - 2 -

## Vorteile der Erfindung

Das erfindungsgemäße Funksprechgerät mit den kennzeichnenden Merkmalen des Hauptanspruchs hat demgegenüber den Vorteil, daß die Einrastzeit des PLL erheblich verkürzt wird. Weiterhin ist es möglich, das Rechenwerk, das als Mikroprozessor ausgebildet sein kann, für andere Aufgaben zu verwenden.

## Zeichnung

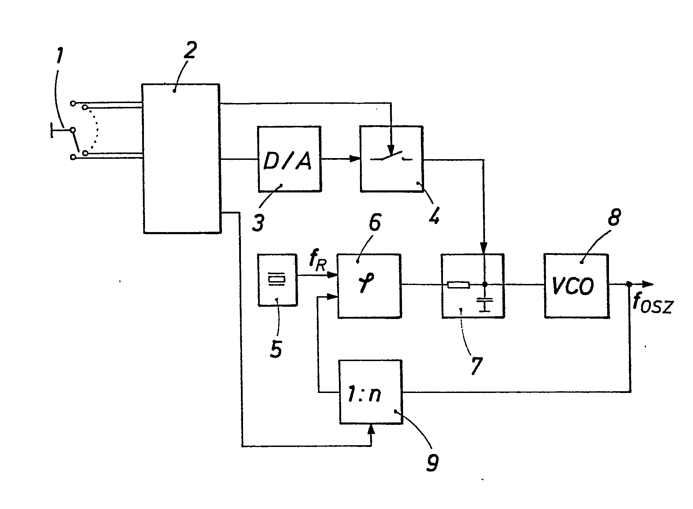

Ein Ausführungsbeispiel der Erfindung ist in der Zeichnung dargestellt und wird in der nachfolgenden Beschreibung näher erläutert. Die einzige Figur zeigt ein Blockschaltbild einer Einrichtung zur Frequenzerzeugung in einem Funksendegerät.

## Beschreibung des Ausführungsbeispiels

In der einzigen Figur ist mit 1 ein Kanalschalter bezeichnet, dessen Schaltstellungen je einem Funkkanal entsprechen. Der Kanalschalter 1 ist mit einem Rechenwerk 2, das als Mikroprozessor ausgebildet ist, verbunden. Dem Rechenwerk 2 folgt ein D/A-Wandler 3, der an einen Schalter 4, der als elektronischer Schalter ausgebildet sein kann, angeschlossen ist. Der Schalter 4 ist mit dem Kondensator des Tiefpasses 7 einer PLL-Schaltung verbunden. Die PLL-Oszillatorschaltung weist einen quarzgesteuerten Bezugsfrequenz-Generator 5, einen Phasenvergleicher 6, einen Tiefpaß 7, einen durch eine elektrische Spannung steuerbaren Oszillator 8 und Frequenzteiler 9 auf. Weiterhin sind der Schalter 4 und die Frequenzteiler 9 mit dem Rechenwerk 2 verbunden. Der Mikroprozessor 2 erzeugt für jede einstellbare Frequenz der PLL-Schaltung, die durch den Kanalschalter 1 gewählt wird, codierte Ausgangssignale, die in dem D/A-Wandler 3 in eine Gleichspannung umgewandelt werden. Über den Schalter 4, der von dem Mikro-

- 3 -

prozessor 2 gesteuert wird, wird bei Kanalwechsel die Gleichspannung kurzzeitig auf den Kondensator des Tiefpasses 7 geschaltet. Bei Kanalwechsel steuert der Mikroprozessor 2 die
Teiler 9 der PLL-Schaltung in der Weise an, daß das Teilerverhältnis geändert wird. Daher liegt am Eingang des Phasenvergleichers 6 eine zur Referenzfrequenz $f_R$, die vom Quarz-
Oszillator 5 geliefert wird, unterschiedliche Frequenz. Dadurch setzt der Regelvorgang der PLL-Schaltung ein. Da aber
gleichzeitig zusätzlich die vom D/A-Wandler 3 abgegebene
Spannung kurzzeitig direkt auf den Kondensator des Tiefpasses 7 geschaltet wird, stellt sich am Ausgang des durch
eine elektrische Spannung steuerbaren Oszillators 8 schnell
eine Frequenz ein, die in der Nähe der Sollfrequenz liegt.
Anschließend wird die Ausgangsfrequenz des gesteuerten
Oszillators 8 über die Teiler 9, den Phasenvergleicher 6
und den Tiefpaß 7 auf die Sollfrequenz geregelt. Gleichzeitig wird der Schalter 4 geöffnet, so daß die Verbindung
zwischen D/A-Wandler 3 und Tiefpaß 7 unterbrochen ist.

Durch das oben beschriebene harte Aufschalten der Gleichspannung auf den Tiefpaß wird die Einrastzeit der PLL-Schaltung erheblich verringert.

Der Mikroprozessor 2 kann innerhalb des Funksprechgerätes
auch andere als die eben beschriebenen Aufgaben (zum Beispiel Kanalanzeige, Vorselektion) übernehmen.

31/79
EK/PLI - Bt/Li
19. Sept. 1979

ROBERT BOSCH GMBH, 7000 Stuttgart

<u>Ansprüche</u>

1. Mehrkanaliges Funksprechgerät mit mindestens einer die Kanalfrequenzen liefernden PLL-Oszillatorschaltung, die mindestens einen Phasenvergleicher, einen Tiefpaß, einen steuerbaren Oszillator und Frequenzteiler aufweist, dadurch gekennzeichnet, daß in einem Rechenwerk (2) der Kanalfrequenz eine bestimmte Spannung zugeordnet ist, die beim Ein- oder Umschalten des Kanals als Steuerspannung zum schnellen Frequenzfang über einen Schalter (4) kurzzeitig auf den steuerbaren Oszillator (8) gegeben wird.

2. Funksprechgerät nach Anspruch 1, dadurch gekennzeichnet, daß die der Kanalfrequenz zugeordnete Spannung über einen D/A-Wandler (3) dem steuerbaren Oszillator (8) zugeführt wird.

3. Funksprechgerät nach Anspruch 1 oder 2, dadurch gekennzeichnet, daß die der Kanalfrequenz zugeordnete Spannung direkt auf den Kondensator des Tiefpasses (7) gelangt.

4. Funksprechgerät nach einem der Ansprüche 1 bis 3, dadurch gekennzeichnet, daß die Frequenzteiler (9) durch das Rechenwerk (2) angesteuert werden.

5. Funksprechgerät nach einem der Ansprüche 1 bis 4, dadurch gekennzeichnet, daß der Schalter (4) durch das Rechenwerk (2) gesteuert wird.

## Europäisches Patentamt

## EUROPÄISCHER RECHERCHENBERICHT

EP 80104959.4

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | <u>DE - A1 - 2 802 981</u> (RCA) <br> + Fig.; Seite 8, Zeilen 7-20; Seite 12, Zeile 19 - Seite 14, Zeile 22 + <br><br> -- | 1,3 | H 04 B 1/40 <br> H 03 L 7/18 |
| | <u>DE - A1 - 2 643 142</u> (OSCILLO-QUARTZ) <br> + Fig. 2; Seite 7, Zeile 1 - Seite 9, Zeile 16 + <br><br> -- | 1,2,5 | |
| | <u>DE - A1 - 2 706 224</u> (ROHDE & SCHWARZ) <br> + Fig. + <br><br> -- | 1,3 | **RECHERCHIERTE SACHGEBIETE (Int. Cl.³)** <br><br> H 03 L 7/00 <br> H 03 J 3/00 |
| D,A | <u>DE - A1 - 2 607 992</u> (ROBERT BOSCH) <br> + Fig. 1 + <br><br> ---- | 1 | H 03 J 5/00 <br> H 03 J 7/00 <br> H 04 B 1/00 |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 21-11-1980 | DRÖSCHER |